**Europäisches Patentamt**

**European Patent Office**

**Office européen des brevets**

(11) Publication number: **0 112 895**
**B1**

(12) **EUROPEAN PATENT SPECIFICATION**

(45) Date of publication of patent specification: **03.02.88**

(21) Application number: **83902349.6**

(22) Date of filing: **08.06.83**

(86) International application number:
**PCT/US83/00905**

(87) International publication number:
**WO 84/00453 02.02.84 Gazette 84/03**

(51) Int. Cl.⁴: **H 03 K 5/153**

(54) **A VOLTAGE DETECTING AND TRANSLATING CIRCUIT.**

(30) Priority: **06.07.82 US 395424**
**07.07.82 US 395958**

(43) Date of publication of application:
**11.07.84 Bulletin 84/28**

(45) Publication of the grant of the patent:
**03.02.88 Bulletin 88/05**

(84) Designated Contracting States:
**DE FR GB NL**

(56) References cited:
**DE-B-2 930 424**
**DE-C-2 840 006**
**GB-A-2 065 404**
**US-A-3 936 676**
**US-A-4 045 688**
**US-A-4 064 405**
**US-A-4 270 190**
**US-A-4 322 639**
**US-A-4 348 596**

**Patent Abstracts of Japan vol. 4, no. 66, 17 May 1980 page 103P11 & JP-A-55-34375**

(73) Proprietor: **MOTOROLA, INC.**
**1303 East Algonquin Road**
**Schaumburg, Illinois 60196 (US)**

(72) Inventor: **RAGHUNATHAN, Kuppuswamy**
**12311 Scribe Drive**
**Austin, TX 78759 (US)**

(74) Representative: **Ibbotson, Harold**
**Motorola Ltd Jays Close Viables Industrial Estate**
**Basingstoke Hants RG22 4PD (GB)**

Courier Press, Leamington Spa, England.

# Description

## Background of the Invention
### 1. Field of the Invention

This invention relates generally to voltage detecting and translating circuits, and more particularly, to a circuit for detecting the presence of an input voltage which is outside the range of the supply voltages of the circuit, and for translating an input signal which is within the range of the supply voltages of the circuit to the greater voltage range of the detected input voltage.

## 2. Description of the Prior Art

In general, voltage detecting circuits are designed to provide a particular output in response to the presence of an input signal which is within the range of the supply voltages of the circuit. For example, U.S. Patent 4,270,190 discloses a sense amplifier which is responsive to a relatively small difference between two signals and which can produce an output which is approximately symmetrical with respect to the mid point of the operating voltage.

In W. German Patent Number DE—C2—2 840 006 there is disclosed a voltage detecting circuit comprising a first field effect transistor having a source region of a first conductivity type, a drain region of the first conductivity type, a current channel region of a second conductivity type between the source and drain regions and a gate electrode adjacent to but insulated from the current channel region; and a second field effect transistor having a source region of the second conductivity type, a drain region of the second conductivity type, a current channel region of the first conductivity type between the source and drain regions, and a gate electrode adjacent to but insulated from the current channel region; wherein the source and channel regions of the first transistor are coupled to a first supply voltage node and the drain region thereof is coupled to an output node, the source and channel regions of the second transistor are coupled together, the drain region thereof is coupled to the output node and the gate electrode thereof is coupled to the gate electrode of the first transistor.

In some applications it is desirable to detect the presence of input voltages which are outside the range of the supply voltages of the detecting circuit. In contrast, voltage translating circuits are designed to provide an output signal which is related to, but different from, an input signal which is within the range of the supply voltages of the circuit. In some applications, it is desirable to provide an output voltage which is outside the range of the normal supply voltages of the translating circuit.

For example, in a typical monolithic microprocessor having an electrically programmable read only memory (EPROM), the supply voltages of the microprocessor will be +5 volts and 0 volts. However, the on-chip EPROM can only be programmed using a programming voltage well outside of these supply voltages. In a typical N-channel device, the programming voltage will be of the order of +20 volts, while in a CMOS device the programming voltage would be of the order of −15 or +20 volts depending upon the conductivity type of the field effect transistors used to form the EPROM storage cells. If the microprocessor is also of the self-programming type, i.e. capable of automatically transferring the contents of an external memory into the on-chip EPROM, some means must be provided to force the device into the self-programming mode. One convenient way for performing this function is to provide a voltage detecting circuit which provides a distinctive output signal only when the programming voltage is applied to a particular input pin of the microprocessor. However, prior art voltage detecting circuits of this type have tended to be of the rather complicated voltage comparator form. In addition, the output signal which such prior art voltage detection circuits provide to indicate the presence of the programming voltage has typically been restricted to the range of the supply voltages.

Some means must also be provided to couple the programming voltage to the EPROM programming logic when the device is forced into the self-programming mode. One convenient way for performing this function is to provide a voltage translation circuit which selectively provides as an output signal the programming voltage when the latter is applied to a particular input pin of the microprocessor. However, prior art voltage translating circuits of this type have tended to be relatively complicated. In addition, such circuits typically require bias voltage generating circuits for biasing the current channel regions of the coupling transistors.

In U.K. Patent Application No. GB—A—2 065 404 there is disclosed a voltage translating circuit comprising a first field effect transistor having a source region of a first conductivity type, a drain region of the first conductivity type, a current channel region of a second conductivity type between the source and drain regions, and a gate electrode adjacent to but insulated from the current channel region; a second field effect transistor having a source region of the second conductivity type, a drain region of the second conductivity type, a current channel region of the first conductivity type between the source and drain regions, and a gate electrode adjacent to but insulated from the current channel region;

a third field effect transistor having a source region of the second conductivity type, a drain region of the second conductivity type, a current channel region of the first conductivity type between the source and drain regions, and a gate electrode adjacent to but insulated from the current channel region; and a fourth field effect transistor having a source region of the second conductivity type, a drain region of the second conductivity type, a current channel region of the first conductivity type between the source and drain regions and a gate electrode adjacent to but insulated from the current channel region;

wherein the source and channel regions of the first transistor are coupled to a first operating voltage node, the drain region thereof is coupled to an output node and the gate electrode thereof is coupled to a first input node; the source and channel regions of the second transistor are coupled to a second node, and the gate electrode thereof is coupled to the first input node;

the source region of the third transistor is coupled to the drain region of the second transistor, the drain region of the third transistor is coupled to the output node, the channel region thereof is coupled to the second node, and the gate electrode thereof is coupled to a third input node; and the source and channel regions of the fourth transistor are coupled together, and the drain region thereof is coupled to the output node.

## Summary of the Invention

An object of the present invention is to provide a simple voltage detecting circuit which may be used for detecting the presence of an input signal outside the range of the supply voltages of the circuit.

Another object of the invention is to provide a voltage detecting circuit which can provide an output signal which is substantially of the same voltage as a detected input signal which is outside the range of the supply voltages of the circuit.

According to a first aspect of the invention, there is provided a voltage detecting circuit of the type disclosed in DE—C2—2 840 006 characterised in that the gate electrodes of the transistors are coupled to a second supply voltage node, and the source and channel regions of the second transistor are coupled to an input node, whereby input signals applied to the input node and having voltages outside the range of the first and second supply voltages may be detected.

Preferably, the on resistance of the second transistor is substantially less than the on resistance of the first transistor.

According to a second aspect of the invention a voltage translating circuit of the type disclosed in GB—A—2 065 404 is characterised in that the source and channel regions of the second transistor, the channel region of the third transistor and the source and channel regions of the fourth transistor are all coupled to a second input node and that the gate electrode of the fourth transistor is coupled to a second operating voltage node.

## Brief Description of the Drawings

Figure 1 is a schematic diagram of a voltage detecting circuit constructed in accordance with the present invention.

Figure 2 is a schematic diagram of a voltage translating circuit constructed in accordance with the present invention.

## Description of the Preferred Embodiment

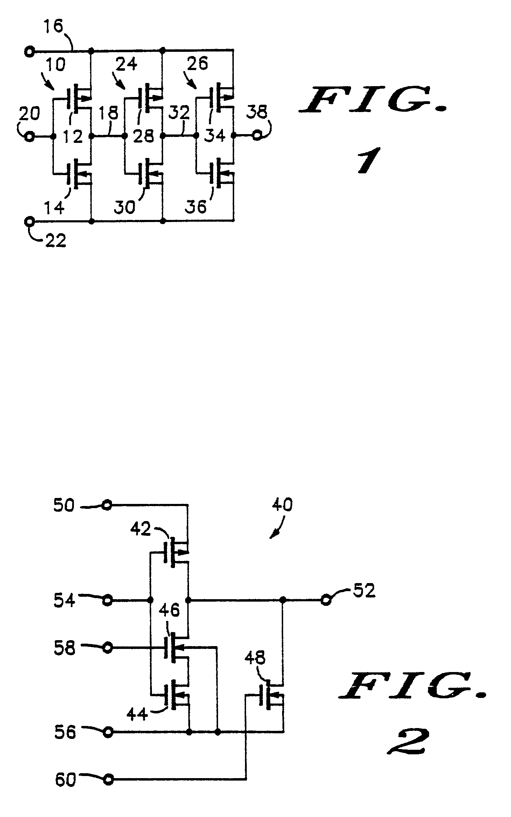

Shown in Figure 1 is a voltage detecting circuit 10 comprised primarily of a P-channel field effect transistor 12 and an N-channel field effect transistor 14. The transistor 12 has a P-type source region coupled to a positive supply voltage node 16, a P-type drain region coupled to a node 18, an N-type current channel region between the source and drain regions thereof and coupled to the positive supply voltage node 16, and a gate electrode adjacent to but insulated from the current channel region thereof and coupled to a negative supply voltage node 20. The transistor 14 has an N-type source region coupled to an input node 22, an N-type drain region coupled to the node 18, a P-type current channel region between the source and drain regions thereof and coupled to the input node 22, and a gate electrode adjacent to but insulated from the current channel region thereof and coupled to the negative supply voltage node 20.

In operation, the positive and negative supply voltage nodes 16 and 20, respectively, will be coupled to a power supply (not shown) capable of developing a potential differential of the order of +3 to +15 volts therebetween. Accordingly, the transistor 12 will be biased in the on or conducting condition, thereby tending to charge the node 18 toward the positive supply voltage. As long as the voltage on the input node 22 is within the range of the supply voltages, the transistor 14 will be biased in the off or non-conducting condition, thereby allowing the transistor 12 to charge node 18 to the positive supply voltage. However, if the input node 22 is coupled to an input signal which is below the negative supply voltage by at least the threshold voltage of the transistor 14, the transistor 14 will be biased in the on or conducting condition, thereby tending to discharge the node 18 toward the voltage of the input signal. Under these conditions, the voltage on the node 18 will settle between the positive supply voltage and the voltage of the input signal, depending upon the relative saturation currents of the transistors 12 and 14.

For example, assuming a current channel width to length ratio of 6/25 for the transistor 12 and 50/7 for the transistor 14, the on resistance of transistor 14 will be substantially smaller than the on resistance of transistor 12, so that the voltage drop across transistor 12 will be much greater than the drop across transistor 14 when the voltage of the input signal is sufficiently below the negative supply voltage to enable transistor 14 to conduct more current than transistor 12. Thus, the voltage on node 18 will be substantially equal to the voltage of the input signal.

In some applications, the grossly imbalanced source and sink currents on the node 18 in the above example may be undesirable. In the illustrated form, transistors 12 and 14 may be significantly smaller than in the example above, since the resulting increase in voltage on the node 18 is compensated for by including additional gain stages 24 and 26. For example, using a "design" input signal of −15 volts, the width to length ratios of transistors 12 and 14 may be 8/15 and 25/10, respectively, so that the resulting on resistance of transistor 14 will be still be smaller than the on resistance of transistor 12. However, the voltage on the node 18 will be in range of about −8 volts when the input signal is −15 volts. This voltage swing is increased by gain stage 24, which comprises a second P-channel field effect transistor 28 and a second N-channel field effect transistor 30 connected the same as the transistors 12 and 14, respectively, but with the gate electrodes thereof coupled to the node 18. If, for example, the width to length ratios of transistors 28 and 30 are selected to be 30/6 and 6/6, respectively, then the switch point of the gain stage 24 will be about 0 volts, and the voltage developed on node 32 will swing between the positive supply voltage and the voltage of the "design" input signal, i.e. −15 volts for the given example. It will be noted however, that the on resistance of the transistor 28 is still somewhat smaller than the on resistance of transistor 30. Balanced currents are obtained while preserving the full voltage swing by gain stage 26, which comprises a third P-channel field effect transistor 34 and a third N-channel field effect transistor 36 connected the same as transistors 12 and 14, respectively, but with the gate electrodes coupled to the node 32. Using conventional width to length ratios for transistors 34 and 36 of 30/6 and 10/6, respectively, then the switch point of the gain stage 26 will be half way between the positive supply voltage and the voltage of the "design" input signal, and the voltage developed on node 38 will swing between the positive supply voltage, i.e. +5 volts, and the voltage of the "design" input signal of −15 volts. In addition, the source and sink currents on node 38 will be the same.

Shown in Figure 2 is a voltage translating circuit 40 comprised of a P-channel field effect transistor 42 and three N-channel field effect transistors 44, 46 and 48. The transistor 42 has a P-type source region coupled to a positive supply voltage node 50, a P-type drain region coupled to an output node 52, an N-type current channel region between the source and drain regions thereof and coupled to the positive supply voltage node 50, and a gate electrode adjacent to but insulated from the current channel region thereof and coupled to a first input node 54. The transistor 44 has an N-type source region coupled to a second input node 56, an N-type drain region, a P-type current channel region between the source and drain regions thereof and coupled to the second input node 56, and a gate electrode adjacent to but insulated from the current channel region thereof and coupled to the first input node 54. The transistor 46 has an N-type source region coupled to the drain region of the transistor 44, an N-type drain region coupled to the output node 52, a P-type current channel region between the source and drain regions thereof and coupled to the second input node 56, and a gate electrode adjacent to but insulated from the current channel region thereof and coupled to a third input node 58. The transistor 48 has an N-type source region coupled to the second input node 56, an N-type drain region coupled to the output node 52, a P-type current channel region between the source and drain regions thereof and coupled to the second input node 56, and a gate electrode adjacent to but insulated from the current channel region thereof and coupled to a negative supply voltage node 60.

In operation, the positive and negative supply voltage nodes 50 and 60, respectively, will be coupled to a power supply (not shown) capable of developing a potential differential of the order of +3 to +15 volts therebetween. In a first mode of operation, the second input node 56 will be coupled to the negative supply voltage, and the third input node 58 will be coupled to the positive supply voltage. Thus, the transistor 46 will be biased in the on or conducting condition and the transistor 48 will be biased in the off or non-conducting condition. Under these conditions, transistors 42 and 44 form an inverter with respect to the first input node 54, with transistor 42 charging output node 52 to the positive supply voltage in response to the first input node 54 being coupled to the negative supply voltage and transistor 44 discharging output node 52 to the negative supply voltage in response to the first input node 54 being coupled to the positive supply voltage.

In a second mode of operation, the second and third input nodes 56 and 58, respectively, will be coupled to a control voltage which is below the negative supply voltage by at least the threshold voltage of the transistors 44 and 48. Thus, the transistor 46 will be biased in the off or non-conducting condition and the transistor 48 will be biased in the on or conducting condition. Under these conditions, transistors 42 and 48 form an inverter with respect to the first input node 54, with transistor 42 being sufficiently strong to charge the output node 52 to the positive supply voltage in response to the first input node 54 being coupled to the negative supply voltage, and transistor 48 being allowed to discharge the output node 52 to the control voltage in response to the first input node 54 being coupled to the positive supply voltage to bias the transistor 42 in the off or non-conducting condition.

One use for the voltage detecting circuit 10 described above is in an electrically programmable read only memory (EPROM) integrated circuit to detect the coupling of a characteristic programming voltage outside the range of the normal supply voltages to a particular input pin, and thus enable the programming logic thereof. The voltage translating circuit 40 is suitable for cooperating with the voltage detecting circuit 10 to perform the word line select function. In this form, the voltage detecting circuit 10 selectively couples either the positive supply voltage or the programming voltage to the gate electrode of the transistor 46 depending upon whether or not the programming voltage is coupled to the second input node 56. In response, the voltage translating circuit 40 selectively couples the programming voltage from the second input node 56 to an associated array word line coupled to output node 52.

From the description given above, it can be seen that the voltage detecting circuit 10 provides as the output thereof the positive supply voltage in the absence of an input signal having a voltage below the negative supply voltage, and the input signal itself when the latter is present. However, due to the complementary nature thereof, the voltage detecting circuit 10 can be easily used to detect an input signal above the positive supply voltage by coupling the negative supply voltage to node 22, the positive supply voltage to node 20, and the input signal to node 16. Assuming the same transistor sizes as in the last example and a "design" input signal of +20 volts, the output on node 38 will be the negative supply voltage in the absence of the input signal, and the input signal of +20 volts when the latter is present. Of course, either form of the voltage detecting circuit 10 may be made to respond to different "design" input signals outside the range of the selected positive and negative supply voltages by applying conventional algorithms to select the sizes of transistors 12 and 14, and, if present, transistors 26—28 and 34—36.

From the description given above, it can also be seen that the voltage translating circuit 40 provides as the output thereof the positive or negative supply voltages selected via the signal applied to the first input node 54 when the signal applied to the second and third input nodes 56 and 58, respectively, are not below the negative supply voltage; and between the positive supply voltage and the voltage on the second and third input nodes 56 and 58, respectively, when the latter is below the negative supply voltage. However, the voltage translating circuit 40 can be easily modified to translate to voltages above the positive supply voltage.

**Claims**

1. A voltage detecting circuit (10) comprising:
a first field effect transistor (12) having a source region of a first conductivity type, a drain region of the first conductivity type, a current channel region of a second conductivity type between the source and drain regions and a gate electrode adjacent to but insulated from the current channel region; and
a second field effect transistor (14) having a source region of the second conductivity type, a drain region of the second conductivity type, a current channel region of the first conductivity type between the source and drain regions, and a gate electrode adjacent to but insulated from the current channel region, wherein the source and channel regions of the first transistor (12) are coupled to a first supply voltage node (16) and the drain region thereof is coupled to an output node (18), the source and channel regions of the second transistor (14) are coupled together, the drain region thereof is coupled to the output node (18) and the gate electrode thereof is coupled to the gate electrode of the first transistor (12); characterised in that the gate electrodes of the transistors (12, 14) are coupled to a second supply voltage node (20) and the source and channel regions of the second transistor (14) are coupled to an input node (22); whereby input signals applied to the input node (22) and having voltages outside the range of the first and second supply voltages may be detected.

2. The voltage detecting circuit (10) of claim 1 wherein the on resistance of the second transistor (14) is smaller than the on resistance of the first transistor (12) to provide a voltage swing on the output node (18) substantially between the voltage on the first supply voltage node (16) and a voltage between the voltage on the second supply voltage node (20) and the voltage on the input node (22).

3. The voltage detecting circuit (10) of claim 2 further including at least one additional gain stage (24) coupled to the output node (18) to provide an output signal having more balance source and sink currents while still providing an output voltage swing between the voltage on the first supply voltage node (16) and the input node (22).

4. The voltage detecting circuit (10) of claim 1 wherein the on resistance of the second transistor (14) is substantially smaller than the on resistance of the first transistor (12) to provide a voltage swing on the output node (18) substantially between the voltage on the first supply voltage node (16) and the voltage on the input node (22).

5. A voltage translating circuit (40) comprising:
a first field effect transistor (42) having a source region of a first conductivity type, a drain region of the first conductivity type, a current channel region of a second conductivity type between the source and drain regions, and a gate electrode adjacent to but insulated from the current channel region;
a second field effect transistor (44) having a source region of the second conductivity type, a drain region of the second conductivity type, a current channel region of the first conductivity type between the source and drain regions, and a gate electrode adjacent to but insulated from the current channel region;
a third field effect transistor (46) having a source region of the second conductivity type, a drain region of the second conductivity type, a current channel region of the first conductivity type between the source and drain regions, and a gate electrode adjacent to but insulated from the current channel region; and
a fourth field effect transistor (48) having a source region of the second conductivity type, a drain region of the second conductivity type, a current channel region of the first conductivity type between the source and drain regions, and a gate electrode adjacent to but insulated from the current channel region:
wherein the source and channel regions of the first transistor (42) are coupled to a first operating voltage node (50), the drain region thereof is coupled to an output node (52) and the gate electrode thereof is coupled to a first input node (54);
the source and channel regions of the second transistor (44) are coupled to a second node (56), and the gate electrode thereof is coupled to the first input node (54);

the source region of the third transistor (46) is coupled to the drain region of the second transistor (44), the drain region of the third transistor (46) is coupled to the output node (52), the channel region thereof is coupled to the second node (56), and the gate electrode thereof is coupled to a third input node (58); and

the source and channel regions of the fourth transistor (48) are coupled together, and the drain region thereof is coupled to the output node (52);

characterised in that the source and channel regions of the second transistor (44), the channel region of the third transistor (46) and the source and channel regions of the fourth transistor (48) are all coupled to a second input node (56) and the gate electrode of the fourth transistor (48) is coupled to a second operating voltage node (60).

**Patentansprüche**

1. Spannungsaufspürschaltung (10) enthaltend:
einen Feldeffekttransistor (12) mit einem Sourcebereich eines ersten Leitfähigkeitstyps, einem Drainbereich des ersten Leitfähigkeitstyps, einem Stromkanalbereich eines zweiten Leitfähigkeitstyps zwischen den Source- und Drainbereichen und einer Gate-Elektrode benachbart, jedoch isoliert von dem Stromkanalbereich; und
einen zweiten Feldeffekttransistor (14) mit einem Sourcebereich des zweiten Leitfähigkeitstyps, einem Drainbereich des zweiten Leitfähigkeitstyps, einem Stromkanalbereich des ersten Leitfähigkeitstyps zwischen den Source- und Drainbereichen und einer Gate-Elektrode benachbart, jedoch isoliert von dem Stromkanalbereich, wobei die Source- und Kanalbereiche des ersten Transistors (12) mit einem ersten Spannungszuführanschluß (16) verbunden sind und der Drainbereich desselben mit einem Ausgangsanschluß (18) verbunden ist, die Source- und Kanalbereiche des zweiten Transistors (14) miteinander verbunden sind, der Drainbereich desselben mit dem Ausgangsanschluß (18) verbunden ist und die Gate-Elektrode desselben mit der Gate-Elektrode des ersten Transistors (12) verbunden ist;
dadurch gekennzeichnet, daß die Gate-Elektroden der Transistoren (12, 14) mit einem zweiten Spannungszuführanschluß (20) verbunden sind und die Source- und Kanalbereiche des zweiten Transistors (14) mit einem Eingangsanschluß (22) verbunden sind; wodurch dem Eingangsanschluß (22) zugeführte Eingangssignale, die Spannungen außerhalb des Bereiches der ersten und zweiten Zuführspannungen aufweisen, ermittelt werden können.

2. Spannungsaufspürschaltung (10) nach Anspruch 1, bei der der Einschaltwiderstand des zweiten Transistors (14) kleiner als der Einschaltwiderstand des ersten Transistors (12) ist, um einen Spannungsausschlag am Ausgangsanschluß (18) im wesentlichen zwischen der Spannung an dem ersten Zuführspannungsanschluß (16) und einer Spannung zwischen der Spannung am zweiten Spannungszuführanschluß (20) und der Spannung am Eingangsanschluß (22) zu erzeugen.

3. Spannungsaufspürschaltung (10) nach Anspruch 2, weiterhin enthaltend wenigstens eine zusätzliche Verstärkerstufe (24), die mit dem Ausgangsanschluß (18) verbunden ist, um ein Ausgangssignal zu erzeugen, das mehr ausgeglichene Source- und Senkströme hat, während sie noch immer einen Ausgangsspannungsausschlag zwischen der Spannung an dem ersten Spannungszuführanschluß (16) und dem Eingangsanschluß (22) erzeugt.

4. Spannungsaufspürschaltung (10) nach Anspruch 1, bei der der Einschaltwiderstand des zweiten Transistors (14) wesentlich kleiner als der Einschaltwiderstand des ersten Transistors (12) ist, um einen Spannungsausschlag am Ausgangsanschluß (18) zu erzeugen, der im wesentlichen zwischen der Spannung an dem ersten Spannungszuführanschluß (16) und der Spannung am Eingangsanschluß (22) liegt.

5. Spannungsumsetzschaltung (40), enthaltend:
einen ersten Feldeffekttransistor (42) mit einem Sourcebereich eines ersten Leitfähigkeitstyps, einem Drainbereich des ersten Leitfähigkeitstyps, einem Stromkanalbereich eines zweiten Leitfähigkeitstyps zwischen den Source- und Drainbereichen und einer Gate-Elektrode benachbart, jedoch isoliert von dem Stromkanalbereich;
einen zweiten Feldeffekttransistor (44) mit einem Sourcebereich des zweiten Leitfähigkeitstyps, einem Drainbereich des zweiten Leitfähigkeitstyps, einem Stromkanalbereich des ersten Leitfähigkeitstyps zwischen den Source- und Drainbereichen und einer Gate-Elektrode benachbart, jedoch isoliert von dem Stromkanalbereich;
einen dritten Feldeffekttransistor (46) mit einem Sourcebereich des zweiten Leitfähigkeitstyps, einem Drainbereich des zweiten Leitfähigkeitstyps, einem Stromkanalbereich des ersten Leitfähigkeitstyps zwischen den Source- und Drainbereichen und einer Gate-Elektrode benachbart, jedoch isoliert von dem Stromkanalbereich; und
einen vierten Feldeffekttransistor (48) mit einem Sourcebereich des zweiten Leitfähigkeitstyps, einem Drainbereich des zweiten Leitfähigkeitstyps, einem Stromkanalbereich des ersten Leitfähigkeitstyps zwischen den Source- und Drainbereichen und einer Gate-Elektrode benachbart, jedoch isoliert von dem Stromkanalbereich;
wobei Source- und Kanalbereiche des ersten Transistors (42) mit einem ersten Betriebsspannungsanschluß (50) verbunden sind, der Drainbereich desselben mit einem Ausgangsanschluß (52) verbunden ist und die Gate-Elektrode desselben mit einem ersten Eingangsanschluß (54) verbunden ist;
die Source- und Kanalbereiche des zweiten Transistors (44) mit einem zweiten Anschluß (56) verbunden sind und die Gate-Elektrode desselben mit dem ersten Eingangsanschluß (54) verbunden ist;

der Sourcebereich des dritten Transistors (46) mit dem Drainbereich des zweiten Transistors (44) verbunden ist, der Drainbereich des dritten Transistors (46) mit dem Ausgangsanschluß (52) verbunden ist, der Kanalbereich desselben mit dem zweiten Anschluß (56) verbunden ist, und die Gate-Elektrode desselben mit dem dritten Eingangsanschluß (58) verbunden ist; und

die Source- und Kanalbereiche des vierten Transistors (48) miteinander verbunden sind und der Drainbereich desselben mit dem Ausgangsanschluß (52) verbunden ist;

dadurch gekennzeichnet, daß die Source- und Kanalbereiche des zweiten Transistors (44), der Kanalbereich des dritten Transistors (46) und die Source- und Kanalbereiche des vierten Transistors (48) sämtlich mit einem zweiten Eingangsanschluß (56) verbunden sind und die Gate-Elektrode des vierten Transistors (48) mit einem zweiten Betriebsspannungsanschluß (60) verbunden ist.

**Revendications**

1. Circuit de détection de tension (10) comportant;

un premier transistor à effet de champ (12) ayant une région de source d'un premier type de conductivité, une région de drain du premier type de conductivité, une région de canal de courant d'un second type de conductivité entre les régions de source et de drain et une électrode de grille voisine mais isolée de la région de canal de courant; et

un second transistor à effet de champ (14) ayant une région de source du second type de conductivité, une région de drain du second type de conductivité, une région de canal de courant du premier type de conductivité entre les régions de source et de drain et une électrode de grille voisine mais isolée de la région de canal de courant, dans lequel les régions de source et de canal du premier transistor (12) sont couplées à un premier point commun de tension d'alimentation (16) et sa région de drain est reliée à un point commun de sortie (18), les régions de source et de canal du second transistor (14) sont reliées ensemble, sa région de drain est reliée au point commun de sortie (18) et son électrode de grille est reliée à l'électrode de grille du premier transistor (12); caractérisé en ce que les électrodes de grille des transistors (12, 14) sont couplées avec un second point commun de tension d'alimentation (20) et les régions de source et de canal du second transistor (14) sont reliées à un point commun d'entrée (22); de manière que des signaux d'entrée appliqués au point d'entrée (22) et ayant des tensions à l'extérieur de la plage de la première et la seconde tensions d'alimentation puissent être détectés.

2. Circuit de détection de tension (10) selon la revendication 1, dans lequel la résistance à l'état débloqué du second transistor (14) est inférieure à la résistance à l'état débloqué du premier transistor (12) pour produire une excursion de tension sur le point commun de sortie (18) pratiquement entre la tension du premier point commun de tension d'alimentation (16) et une tension entre la tension sur le second point commun de tension d'alimentation (20) et la tension au point commun d'entrée (22).

3. Circuit de détection de tension (10) selon la revendication 2, comportant en outre au moins un étage de gain supplémentaire (24) couplé avec le point commun de sortie (18) pour produire un signal de sortie ayant un meilleur équilibrage des courants de source et de prélèvement tout en produisant encore une excursion de tension de sortie entre la tension du premier point commun de tension d'alimentation (16) et du point commun d'entrée (22).

4. Circuit de détection de tension (10) selon la revendication 1, dans lequel la résistance à l'état débloqué du second transistor (14) est nettement inférieure à la résistance à l'état débloqué du premier transistor (12) pour produire une excursion de tension au point commun de sortie (18) pratiquement entre la tension au premier point commun de tension d'alimentation (16) et la tension au point commun d'entrée (22).

5. Circuit de conversion de tension (40) comportant:

un premier transistor à effet de champ (42) ayant une région de source d'un premier type de conductivité, une région de drain du premier type de conductivité, une région de canal de courant d'un second type de conductivité entre les régions de source et de drain et une électrode de grille voisine mais isolée de la région de canal de courant;

un second transistor à effet de champ (44) ayant une région de source du second type de conductivité, une région de drain du second type de conductivité, une région de canal du premier type de conductivité entre les régions de source et de drain et une électrode de grille voisine mais isolée de la région de canal de courant;

un troisième transistor à effet de champ (46) ayant une région de source du second type de conductivité, une région de drain du second type de conductivité, une région de canal de courant du premier type de conductivité entre les régions de source et de drain et une électrode de grille voisine mais isolée de la région de canal de courant; et

un quatrième transistor à effet de champ (48) ayant une région de source du second type de conductivité, une région de drain du second type de conductivité, une région de canal de courant du premier type de conductivité entre les régions de source et de drain et une électrode de grille voisine mais isolée de la région de canal de courant;

dans lequel

les régions de source et de canal du premier transistor (42) sont couplées avec un premier point de tension de fonctionnement (50), sa région de drain est couplée avec un point commun de sortie (52) et son électrode de grille est couplée avec un premier point commun d'entrée (54);

les régions et de canal du second transistor (44) sont couplées avec un second point commun (56) et son électrode de grille est couplée avec le premier point commun d'entrée (54);

la région de source du troisième transistor (46) est couplée avec la région de drain du second transistor (44), la région de drain du troisième transistor (46) est couplée avec le point commun de sortie (52), sa région de canal est couplée avec le second point (56) et son électrode de grille est couplée avec un troisième point d'entrée (58); et les régions de source et de canal du quatrième transistor (48) sont couplées ensemble et sa région de drain est couplée avec le point commun de sortie (52);

caractérisé en ce que les régions de source et de canal du second transistor (44), la région de canal du troisième transistor (46) et les régions de source et de canal du quatrième transistor (48) sont toutes couplées avec un second point commun d'entrée (56) et l'électrode de grille du quatrième transistor (48) est couplée avec un second point commun de tension de fonctionnement (60).

*FIG. 1*

*FIG. 2*